## Europäisches Patentamt
## European Patent Office
## Office européen des brevets

(19)

(11) Publication number: **0 017 479**
**B1**

(12) **EUROPEAN PATENT SPECIFICATION**

(45) Date of publication of patent specification: **07.09.83**

(21) Application number: **80301055.2**

(22) Date of filing: **02.04.80**

(51) Int. Cl.³: **G 11 C 11/24,** G 06 F 1/04, H 03 K 5/15

(54) Memory refresh control apparatus.

(30) Priority: **02.04.79 JP 39550/79**

(43) Date of publication of application:
**15.10.80 Bulletin 80/21**

(45) Publication of the grant of the patent:
**07.09.83 Bulletin 83/36**

(84) Designated Contracting States:
**DE FR GB SE**

(56) References cited:
FR - A - 2 349 916
FR - A - 2 371 747
US - A - 3 790 961
US - A - 3 800 295
US - A - 3 811 117
US - A - 3 866 188
US - A - 4 040 122
US - A - 4 106 108
US - A - 4 133 051

THE SEMICONDUCTOR MEMORY BOOK, INTEL, Wiley Editor, 1978, NEW YORK (US) J. COE: "Design with 16K dynamic rams", pages 130—138

(73) Proprietor: **FUJITSU LIMITED**
1015, Kamikodanaka Nakahara-ku
Kawasaki-shi Kanagawa 211 (JP)

(72) Inventor: **Tanaka, Yoshikazu**
No. 424, Seki Tama-ku
Kawasaki-shi, Kanagawa, 214 (JP)
Inventor: **Shirai, Hitoshi**
No. 2612-27-9-402, Tohkaichiba-cho Midori-ku
Yokohama-shi, Kanagawa, 227 (JP)
Inventor: **Kan'o, Yoshiharu**
No. 350-2-206, Nishihassaku-cho Midori-ku
Yokohama-shi, Kanagawa, 227 (JP)

(74) Representative: **Bedggood, Guy Stuart et al,**
Haseltine Lake & Co. Hazlitt House 28
Southampton Buildings Chancery Lane
London WC2A 1AT (GB)

(56) References cited:
THE SEMICONDUCTOR MEMORY BOOK, INTEL, Wiley Editor, 1978, NEW YORK (US) FIELLAND: "Dynamic rams used with microprocessors", pages 139—181
ELECTRONICS, vol. 52, nr. 4, February 15, 1979 NEW YORK (US) D. C. FORD et al.: "64-K dynamic RAM has pin that refreshes", pages 141—147

Courier Press, Leamington Spa, England.

Memory refresh control apparatus

This invention relates to memory refresh control apparatus.

Recently, memories using dynamic, random access memory elements formed of MOS transistors and the like have been increasing in storage capacity. Naturally, an increase in storage capacity of such a memory causes an increase in the number of refresh addresses, that is, the number of addresses of storage locations which must be refreshed. Conventionally, refresh control for memories of this kind involves producing, as refresh addresses, in a refresh control circuit, addresses corresponding to respective combinations of $n$ bits, and generating over a given period of time refresh clock signals, corresponding to the respective refresh addresses and indicating $2^n$ refresh times ($n$=number of bits in the addresses), and applying the addresses and the refresh clock signals directly to memory elements to be refreshed.

If such conventional refresh control is applied to a mass storage device with an increased number of refresh addresses, it is necessary that the number of refresh clock signals to be sent out be increased in correspondence to the increased number of refresh addresses. This has required a longer refresh time, resulting in reduced efficiency of utilization of the storage device. Further, since the number of bits constituting each refresh address has to be increased, it has been necesary to increase the number of bits in the refresh address data sent out from a refresh control circuit provided in a central processor unit. To provide for this, a central processor unit has had to be equipped with different interfaces for memories with different numbers of refresh addresses.

According to the present invention there is provided memory refresh control apparatus comprising:

a refresh control circuit operable to generate successive $n$-bit addresses, suitable for addressing a first memory having $2^n$ addresses, and operable to produce, over a given period of time, $2^n$ refresh clock signals for designating $2^n$ refresh time, characterised by:—

a circuit operable to divide each of the $2^n$ refresh clock signals into $2^N$ divided refresh clock signals; and

an overhead bit generator arranged to be supplied with the divided refresh clock signals and operable to provide, in dependence, thereupon, successive N-bit addresses, wherein the $n$-bit addresses available from the refresh control circuit are combined with the N-bit addresses generated by the overhead bit generator to provide (N+n)-bit refresh addresses for use in refreshing instead of said first memory a second memory having $2^{n+N}$ addresses to be refreshed by the divided refresh clock signals.

The present invention provides memory refresh control which enables constant refresh control of a memory without the need for modification of the arrangement of a refresh control facility of a central processor unit or the like even when the number of refresh addresses of a memory is increased, from $2^n$ to $2^{n+N}$.

The present invention provides refresh control for a memory that can maintain a high memory utilization efficiency without increasing the number of refresh clock signals to be supplied from a refresh control circuit over a given period of time (i.e. without increasing clock signal frequency) even if the number of refresh addresses of a storage device is increased.

The present invention provides for memory refresh control which permits refresh control of a memory requiring refresh addresses of $n+N$ bits to take place over the same refresh time as is needed for a memory that can be refreshed with $n$-bit refresh addresses only, thereby to prevent reduction of the utilization efficiency of a memory and throughput of a central processor unit.

Reference is made, by way of example, to the accompanying drawings, in which:—

Fig. 1 is a schematic connection diagram illustrative of a conventional memory refresh control arrangement;

Fig. 2 is a timing chart for assistance in explanation of the operation of the arrangement illustrated in Fig. 1;

Fig. 3 is a schematic connection diagram illustrating the general form of an embodiment of the present invention;

Fig. 4 is a timing chart for assistance in explanation of the operation of the embodiment of Fig. 3;

Fig. 5 is a circuit diagram illustrating in detail a circuit for use in an embodiment of the present invention having the general form of Fig. 3; and

Fig. 6 is a timing chart for assistance in explanation of the operation of the circuit illustrated in Fig. 5.

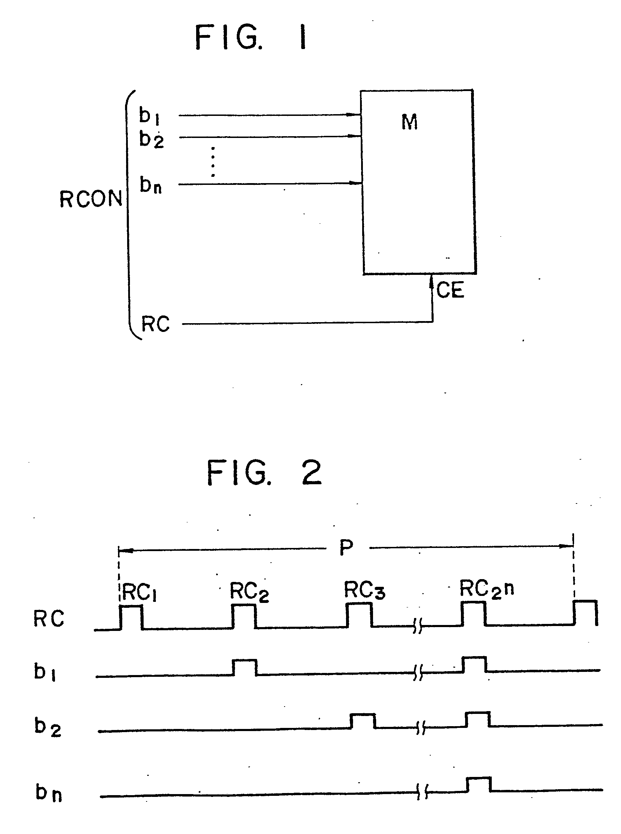

Fig. 1 is a connection diagram showing a memory refresh control arrangement as heretofore employed, and Fig. 2 is a timing chart explanatory of its operation. In Fig. 1, M is a memory, which has $2^n$ refresh addresses. Each refresh address must be refreshed at time intervals P, for example of 2mS duration.

For a control arrangement as shown in Fig. 1, a central processor or the like is provided with a refresh control circuit RCON which yields refresh addresses, corresponding to respective combinations of $n$ bits, and refresh clock signals for specifying $2^n$ refresh times each refresh time corresponding to a respective refresh address, over the interval of time P. The memory M is subjected to refresh control applied by the refresh control circuit RCON.

In Fig. 1, RC is a refresh clock input terminal, to which refresh clock signals $RC_1$, $RC_2$, $RC_3 \ldots RC_2n$ are applied from the refresh control circuit RCON over the interval of time P, as shown in Fig. 2; and $b_1$, $b_2 \ldots b_n$ designate respective bits of the $n$ bit refresh address data, which bits are assigned values by the refresh control circuit RCON at each refresh clock signal time. That is, as exemplified in Fig. 2, at the time of refresh clock signal $RC_1$ (more accurately— throughout the duration of the refresh clock signal $RC_1$) refresh address data 0, $0\sim0$, ($b_1=0$, $b_2=0, \ldots b_n=0$) is provided from RCON; over the duration of the refresh clock signal $RC_2$ refresh address data 1, $0\sim0$ ($b_1=1$; $b_2$, $b_3 \ldots =0$) is provided, over the duration of the refresh clock signal $RC_3$ refresh address data 0, $1\sim0$ ($b_1=0$; $b_2=1$; $b_3$, $b_4 \ldots =0$) is provided; and over the duration of the last refresh clock signal $RC_2n$ refresh address data 1, $1\sim1$ ($b_1$, $b_2$, $b_3 \ldots =1$) is provided. The refresh clock signals $RC_1$ to $RC_2n$ are supplied to a chip enable terminal CE of the memory M and memory address refresh takes place at the times designated by the refresh clock signals. All the addresses are refreshed within interval P and the refresh operations are then repeated.

As described above, the refresh clock signals $RC_1$, $RC_2$, $RC_3 \ldots RC_2n$ corresponding in number to the number of refresh addresses of the memory M are delivered to the memory to refresh the respective refresh addresses at the times specified by the respective refresh clock signals.

If the memory capacity of the memory M is increased, the number of refresh addresses is also increased. In such a case, when the aforementioned conventional refresh control system of Fig. 1 is employed, it is necessary that the number of refresh clock signals to be sent out to refresh all the addresses be increased in accordance with the increased number of refresh addresses. This leads to longer refresh time and reduced memory utilization efficiency. Moreover, since an increased number of bits are needed to make up refresh address data, it is necessary to increase the number of bits which are sent out from the central processor unit for forming the refresh address data. To this end, the central processor unit has had to be equipped with different interfaces for memories having different numbers of refresh addresses.

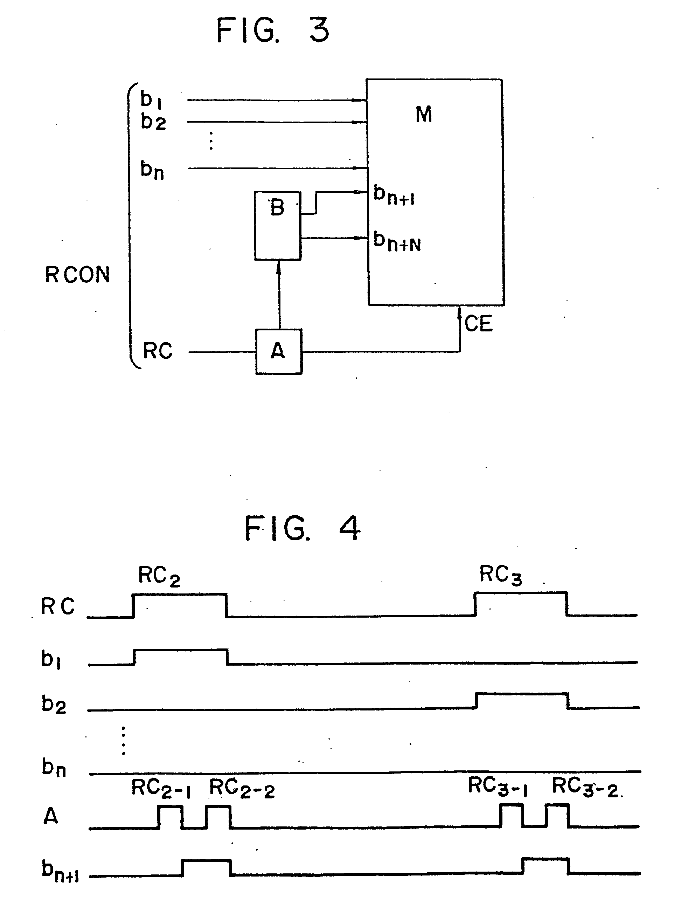

Fig. 3 illustrates an embodiment of the present invention.

In Fig. 3, M is a memory which must be refreshed and which has $2^{n+N}$ refresh addresses. Refresh address data is provided by $n+N$ bits $b_1$, $b_2$ to $b_n$ and $b_{n+1}$ to $b_{n+N}$. B is a circuit for producing a part of the refresh address data, i.e. N "overhead" bits $b_{n+1}$ to $b_{n+N}$; and A is a circuit for dividing each refresh clock signal into $2^N$ in terms of time (i.e. for providing $2^N$ shorter signals within the duration of one refresh clock signal). The $n$ bits $b_1$ to $b_n$ of the refresh address data are derived from refresh control circuit RCON of the central processor unit or the like, whereas the N overhead bits $b_{n+1}$ to $b_{n+N}$ are provided from the circuit B. The refresh clock signals are provided from RCON.

Fig. 4 is a timing chart explanatory of the operation of the example shown in Fig. 3.

In the example of Fig. 3, there are provided from the refresh control circuit RCON, over the interval of time P, $2^n$ refresh clock signals corresponding to the number of refresh addresses that can be made up of the $n$ bits $b_1$ to $b_n$, as in the case of the conventional arrangement shown in Fig. 1. In Fig. 4 there are shown on a scale enlarged as compared with Fig. 2, the bits making up refresh addresses corresponding to the refresh clock signals $RC_2$ and $RC_3$ in Fig. 2. Fig. 4 illustrates a case in which over the duration of the refresh clock signals $RC_2$ the bits $b_1$ to $b_n$ are provided in the form 1, $0\sim0$ (i.e. $b_1=1$; $b_2$, $b_3 \ldots b_n=0$) and over the duration of the refresh clock signal $RC_3$ the bits $b_1$ to $b_n$ are provided in the form 0, $1\sim0$ ($b_1=0$; $b_2=1$; $b_3$, $b_4 \ldots b_n=0$).

In this case, assuming that N=1 (one overhead bit), the refresh clock signals $RC_2$, $RC_3$, $\ldots$ supplied to the terminal RC of the refresh clock divider A are each divided by the divider A into $2^N$ ($=2^1$) signals, that is, into two signals both occurring within the duration of the clock signal $RC_2$, $RC_3$ concerned. In Fig. 4, A shows the thus divided clock signals $RC_{2-1}$, $RC_{2-2}$, $RC_{3-1}$ and $RC_{3-2}$.

When applied to the terminal RC, the refresh clock signal $RC_2$ is divided by the refresh divider A into divided clock signals $RC_{2-1}$ and $RC_{2-2}$, which are fed to the circuit B. The circuit B has, for example, a binary counter for counting the clock signals fed thereto and provides the count result as a bit $b_{n+1}$ (the overhead bit). At the end of the preceding refresh clock signal ($RC_1$), the binary counter returns to zero and its output bit $b_{n+1}$ is zero. Accordingly, when the divided block signal $RC_{2-1}$ is supplied from the divider A to the chip enable terminal CE of the memory M, an address specified by the refresh address data 1, $0\sim0$, 0 ($b_1=1$; $b_2$ to $b_n=0$); and the last bit 0 being $b_{n+1}$) is refreshed.

The binary counter of the circuit B counts 1 at the fall of the divided clock signal $RC_{2-1}$ and provides 1 as its output bit $b_{n+1}$. Accordingly, since 1, $0\sim0$, 1 (the last bit 1 being $b_{n+1}$) is then applied as the refresh address data, when the next divided clock signal $RC_{2-2}$ is applied to the chip enable terminal CE, the address assigned by that refresh address data is refreshed.

The binary counter of the circuit B counts the fall of the divided clock signal $RC_{2-2}$ and returns to zero.

Similarly, in the case of the refresh clock signal $RC_3$, too, addresses corresponding to address data 0, $1\sim0$, 0 ($b_1=0$; $b_2=1$; $b_3$ to $b_n=0$, $b_{n+1}=0$) and 0, $1\sim0$, 1 ($b_1=0$; $b_2=1$; $b_3$ to $b_n=0$; $b_{n+1}=1$) are refreshed.

In this way, all addresses corresponding to the combined address data made up of $n+1$ bits ($b_1$ to $b_n$ and $b_{n+1}$) are refreshed by the refresh clock signals $RC_1$ to $RC_2n$ which correspond to combined address data made up of $n$ bits provided over a given interval of time.

In the above description, N has been assumed to be 1, but N can be made 2 or more by providing a $2^N$ step counter in the circuit B, producing N output bits corresponding to bits $b_{n+1}$ to $b_{n+N}$ of address data and dividing each refresh clock signal into $2^N$ divided signals in divider A. In other words, the number of refresh addresses can be increased twice, four times, ... $2^N$ times.

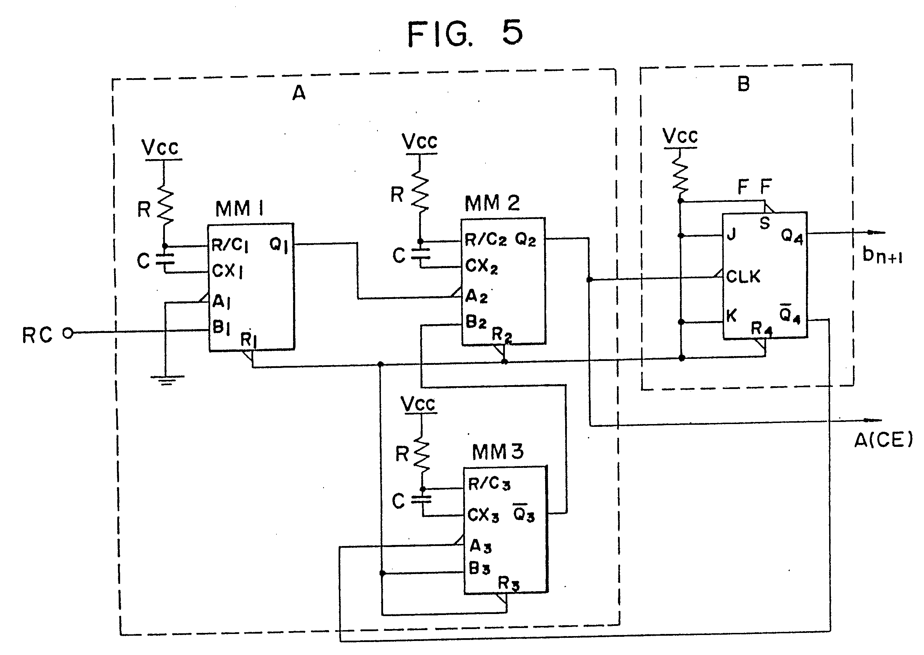

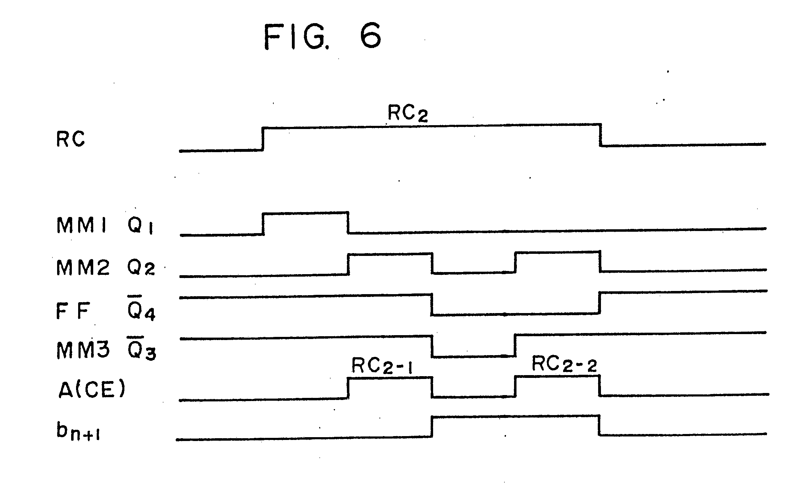

Fig. 5 is a detailed circuit diagram illustrating one example of a circuit A for dividing the refresh clock signals into two in terms of time and a circuit B for producing one overhead bit ($b_{n+1}$) in a case in which $N=1$, that is, in a case in which one bit is added to $n$ bits sent from the refresh control circuit RCON. Fig. 6 is a timing chart explanatory of the operation of the circuits of Fig. 5.

In Fig. 5, circuit A is a circuit by means of which refresh clock signals $RC_1$, $RC_2$, ... $RC_2n$ fed to terminal RC from the refresh control circuit RCON are each divided into two in terms of time, and the circuit B is a circuit for producing one overhead bit $b_{n+1}$.

The circuit A comprises three monostable multivibrators MM1, MM2 and MM3. When voltages at the input terminals $A_1$, $A_2$ and $A_3$ of MM1, MM2, and MM3 are low ("0") the monostable multivibrators are each triggered by the rise of input signals applied to their input terminals $B_1$, $B_2$ and $B_3$; and when the voltages at the input terminals $B_1$, $B_2$ and $B_3$ are high ("1"), the multivibrators are each triggered by the fall of input signals applied to their input terminals $A_1$, $A_2$ and $A_3$. Upon triggering of the monostable multivibrators MM1, MM2 and MM3, outputs at their output terminals $Q_1$, $Q_2$ and $\overline{Q}_3$ are each inverted and then returned to their original state after respective fixed periods of time which are determined for the respective multivibrators by respective capacitances C and resistors R respectively connected to terminals $R/C_1$, $R/C_2$ and $R/C_3$ and terminals $CX_1$, $CX_2$ and $CX_3$ of the multivibrators. Input terminals $R_1$ and $R_2$ and $R_3$ are reset terminals but, in Fig. 5, they are always supplied with a high voltage from a power source Vcc and thereby made inoperative.

The circuit B comprises one J-K flip-flop FF arranged to form a 1-digit binary counter. The J-K flip-flop FF is supplied at each of its input terminals J and K, set input terminal S and reset input terminal $R_4$ with a high voltage from power source Vcc. The J-K flip-flop FF is designed to block inputs from these input terminals, invert the state of its output terminals $Q_4$ and $\overline{Q}_4$ at the fall of an input signal (from multivibrator MM2) to its clock input terminal CLK and maintain the inverted state until the next input signal from multivibrator MM2 falls.

Now, a description will be given, with reference to Fig. 6, of the operation of the circuit shown in Fig. 5.

When applied from the refresh control circuit RCON to the input terminal RC as indicated by $RC_2$ in Fig. 6, a refresh control clock signal is fed first to the input terminal $B_1$ of the monostable multivibrator MM1 to trigger it at the rise of the refresh control clock signal $RC_2$, whereby the output from output terminal $Q_1$ is inverted from low to high level and then restored to the original state (low level) after a certain period of time. The time during which the voltage at the output terminal $Q_1$ is high is determined by the capacitor C and the resistor R respectively connected to the terminals $R/C_1$ and $CX_1$ of the monostable multivibrator MM1; this time is selected so that bit information $b_1$ to $b_n$ and $b_{n+1}$ indicating a refresh address may be stably applied to the memory (M in Fig. 3). In Fig. 6, $MM1Q_1$ shows the output waveform occurring at the output terminal $Q_1$ os the monostable multivibrator MM1. Upon the fall of the output from the output terminal $Q_1$, the certain period of time after triggering of the monostable multivibrator MM1, the monostable multivibrator MM2, which is supplied at its input terminal $A_2$ with the output from the abovesaid output terminal $Q_1$, is triggered and inverts the output at its output terminal $Q_2$ from low to high level and then restores the output to the original state after a certain period of time. The resulting output signal from output terminal $Q_2$ (see $MM2Q2$ in Fig. 6, first pulse-like signal) is applied as a divided refresh control clock signal $RC_{2-1}$ to the chip enable terminal CE of the memory M, as shown in Fig. 6. A(CE), thereby to achieve memory refreshing. At this time, however, the output at output terminal $Q_4$ of J-K flip-flop FF is at a low voltage, and the bit $b_{n+1}$ which is applied as an overhead bit of the refresh address from the output terminal $Q_4$ represents "0". The J-K flip-flop FF of the circuit B serves as a 1-digit binary counter and counts the falls of the input signals, and when two falls are counted, the output at the output terminal $Q_4$ returns to "0".

The certain period of time during which the output at the output terminal $Q_2$ of the monostable multivibrator MM2 remains high in level is selected, by choosing the values of the capacitor C and the resistor R connected to terminals thereof, to be sufficient for the memory M to complete its refreshing.

When the output at the output terminal $Q_2$ of the monostable multivibrator MM2 returns to the low level after the above period of time, that is, when the divided refresh clock signal $RC_{2-1}$ ends, since the signal applied to the input terminal CLK of flip-flop FF falls (from the high to the low level), the J-K flip-flop FF inverts its state, inverting the output voltages at its output terminals $Q_4$ and $\overline{Q}_4$. The overhead bit $b_{n+1}$

provided as a "0" (a low voltage) from the output terminal $Q_4$ of the J-K flip-flop FF becomes "1" (a high voltage), and the output from the output terminal $\overline{Q}_4$ changes from a high voltage to a low voltage. In Fig. 6, $FF\overline{Q}_4$ shows the output waveform occurring at the output terminal $\overline{Q}_4$ of the J-K flip-flop FF and $b_{n+1}$ the output waveform at the output terminal $Q_4$.

Since the input to the input terminal $B_3$ of the monostable multivibrator MM3 of the circuit A is held by the power source Vcc at high level and the input to input terminal $A_3$ falls due to the output inversion at the output terminal $\overline{Q}_4$ of the J-K flip-flop FF, the monostable multivibrator MM3 is triggered by the fall of the input to $A_3$ and the output at its output terminal $\overline{Q}_3$ changes from high to low level and returns to high level after the certain period of time determined by the capacitor C and the resistor R respectively connected to the terminals $R/C_3$ and $CX_3$ of MM3. This certain period of time is selected to permit stable application of the refresh address to the memory M.

When the monostable multivibrator MM3 is restored after the elapse of the abovesaid certain period of time, the input to the input terminal $B_2$ of the monostable multivibrator MM2 rises and the monostable multivibrator MM2 is thereby triggered again. The output at output terminal $Q_2$ of MM2 changes from low to high level and remains high for a certain period of time, and the high level output is provided as a divided refresh control block $RC_{2-2}$ to the chip enable terminal CE of the memory M. At this time, "1" is sent out as the overhead bit $b_{n+1}$, as described previously.

In Fig. 6, A(CE) shows the signal waveform which is supplied to the chip enable terminal CE of the memory M from the circuit A. Since the signal to the chip enable terminal CE is branched from the output of the output terminal $Q_2$ of the monostable multivibrator MM2, the former has the same waveform as the latter. Further, $b_{n+1}$ shows a waveform which is sent out as the overhead bit from the output terminal (indicated by $b_{n+1}$) of the circuit B. The waveforms A(CE) and $b_{n+1}$ are identical with those of the corresponding signals A and $b_{n+1}$ in Fig. 4.

The time constants of the monostable multivibrators MM1, MM2 and MM3 are set so that the second divided refresh clock $RC_{2-2}$ ends as or before the refresh clock $RC_2$ ends.

In a case in which N>1, use is made of a circuit A formed as an N divider by cascade-connecting N circuits each similar in construction to circuit A as described with reference to Fig. 5 and monostable multivibrators MM1 to MM3 respectively are given time constants reduced by an appropriate factor, 1/2 to 1/N, and a circuit B is used which is formed as a $2^N$-step counter by cascade connecting N circuits identical in construction with the circuit B described with reference to Fig. 5. This circuit arrangement is applicable to the case of N overhead bits $b_{n+1}$ to $b_{n+N}$.

In the above described embodiment of Fig. 5, monostable multivibrators and a J-K flip-flop are combined to obtain the waveforms shown in Fig. 6, but the monostable multivibrators may be replaced by a delay-line or gate delay.

In memory refresh control apparatus for refresh control of a memory having, as refresh addresses, addresses respectively corresponding to combinations of $n+N$ bits, there is provided a refresh control circuit which yields, as refresh addresses, addresses respectively corresponding to combinations of $n$ bits and which generates, over a certain period of time, refresh clock signals respectively corresponding to the abovesaid n-bit addresses for specifying $2^n$ refresh times, a circuit which divides each of the refresh block signals into $2^N$ divided clock signals and an overhead bit generator which is supplied with the divided clock signals to produce successively addresses respectively corresponding to combinations of N bits for the successive divided clock signals. The $n$ bits available from the refresh control circuit are combined with the N bits generated by the overhead bit generator and then applied as an address of $n+N$ bits to a memory, which is refreshed by the divided block signals. The refresh clock divider may be composed of monostable multivibrators of suitable time constants, and the overhead bit generator may be constituted by a counter.

## Claims

1. Memory refresh control apparatus comprising:
a refresh control circuit operable to generate successive n-bit addresses suitable for addressing a first memory having $2^n$ addresses, and operable to produce, over a given period of time, $2^n$ refresh clock signals for designating $2^n$ refresh times, characterised by:—
a circuit operable to divide each of the $2^n$ refresh clock signals into $2^N$ divided refresh clock signals; and
an overhead bit generator arranged to be supplied with the divided refresh clock signals and operable to provide, in dependence thereupon, successive N-bit addresses, wherein the $n$-bit addresses available from the refresh control circuit are combined with the N-bit addresses generated by the overhead bit generator to provide (N+n) bit refresh addresses for use in refreshing instead of said first memory a second memory having $2^{n+N}$ addresses to be refreshed by the divided refresh clock signals.

2. Memory refresh control apparatus according to Claim 1, wherein the refresh clock dividing circuit comprises a plurality of monostable multivibrators.

3. Memory refresh control apparatus according to Claim 1, wherein the overhead bit generator is constituted by a counter which counts divided refresh clock signals and which is restored to a zero count after every count of N divided refresh clock signals.

## Revendications

1. Dispositif de commande de régénération pour une mémoire comprenant:
   un circuit de commande de régénération capable de générer des adresses à n bits successives, convenant pour l'adressage d'une première mémoire ayant $2^n$ adresses, et capable de produire, sur une durée donnée, $2^n$ signaux d'horloge de régénération pour désigner $2^n$ instants de régénération, caractérisé par:
   un circuit capable de diviser chacun des $2^n$ signaux d'horloge de régénération en $2^N$ signaux d'horloge de régénération divisés; et
   un générateur de bits supplémentaires conçu de façon à recevoir les signaux d'horloge de régénération divisés et capable de fournir, sous la dépendance de ces derniers, des adresses successives à N bits, les adresses à $n$ bits fournies par le circuit de commande de régénération étant combinées avec les adresses à N bits générées par le générateur de bits supplémentaires pour donner des adresses de régénération à (N+n) bits destinées à être utilisées pour régénérer, au lieu de ladite première mémoire, une seconde mémoire ayant $2^{n+N}$ adresses, devant être régénérées par les signaux d'horloge de régénération divisés.

2. Dispositif de commande de régénération pour une mémoire selon la revendication 1, dans lequel le circuit de division d'horloge de régénération comprend plusieurs multivibrateurs monostables.

3. Dispositif de commande de régénération pour une mémoire selon la revendication 1, dans lequel le générateur de bits supplémentaires est constitué par un compteur qui compte les signaux d'horloge de régénération divisés et qui est ramené à un compte de zéro chaque fois qu'il a compté N signaux d'horloge de régénération divisés.

## Patentansprüche

1. Gerät zum Steuern des Auffrischens eines Speichers mit einem Auffrischsteuerkreis, der so betrieben wird, daß er aufeinanderfolgende n-Bit-Adressen erzeugt, die zum Adressieren eines ersten Speichers mit $2^n$ Adressen geeignet sind, und der so betrieben wird, daß er über eine gegebene Zeitperiode $2^n$ Auffrischtaktsignale zum Bezeichnen von $2^n$ Auffrischzeiten erzeugt, gekennzeichnet durch einen Kreis, der so betrieben wird, daß er jedes der $2^n$-Auffrischtaktsignale in $2^N$ Teilauffrischtaktsignale teilt, und einen Generator für zusätzliche Informationsschritte, der so ausgebildet ist, daß er mit den Teilauffrischtaktsignalen gespeist wird, und der so betrieben wird, daß er in Abhängigkeit davon aufeinanderfolgende N-Bit-Adressen schafft, wobei die n-Bit-Adressen, die von dem Auffrischsteuerkreis erhalten werden, mit den N-Bit-Adressen, die durch den Generator für die zusätzlichen Informationsschritte erzeugt werden, kombiniert werden, um (N+n)-Bit-Auffrischadressen zum Auffrischen eines zweiten Speichers mit $2^{n+N}$ Adressen anstelle des ersten Speichers zu schaffen, der durch die Teilauffrischtaktsignale aufgefrischt werden soll.

2. Gerät nach Anspruch 1, in dem der Aufrischtaktteilkreis mehrere monostabile Multivibratoren enthält.

3. Gerät nach Anspruch 1, in dem der Generator für zusätzliche Informationsschritte durch einen Zähler gebildet ist, der die Teilauffrischtaktsignale zählt und der nach jeder Zählung von N Teilauffrischtaktimpulsen auf die Zählung Null zurückgestellt wird.

# FIG. 1

# FIG. 2

# FIG. 3

# FIG. 4

FIG. 5

# FIG. 6

RC            $RC_2$

MM1  $Q_1$

MM2  $Q_2$

F F    $\overline{Q}_4$

MM3  $\overline{Q}_3$

A(CE)    $RC_{2-1}$    $RC_{2-2}$

$b_{n+1}$

0 017 479

4